# EUROPEAN PATENT APPLICATION

(11) **EP 3 030 054 A1**
(43) Date of publication of application: **08.06.2016**
(21) Application number: 14832214.2
(22) Date of filing: 17.07.2014
(51) Int. Cl.: H05K 1/02, H01L 23/12, H05K 1/11, H05K 3/40, H05K 3/46

(54) **WIRING SUBSTRATE AND METHOD FOR PRODUCING SAME**

(30) Priority: 02.08.2013 JP 2013160885; 04.06.2014 JP 2014115372
(71) Applicant: NGK SPARK PLUG CO., LTD., Nagoya-shi, Aichi 467-8525 (JP)
(72) Inventor: TSUNEMI, Daiki, Nagoya-shi Aichi 467-8525 (JP); MORITA, Masahito, Nagoya-shi Aichi 467-8525 (JP); KITO, Naoki, Nagoya-shi Aichi 467-8525 (JP); IKAWA, Tatsuharu, Nagoya-shi Aichi 467-8525 (JP); KODAMA, Hiroyuki, Nagoya-shi Aichi 467-8525 (JP)
(74) Representative: Main, James Edward
(86) International application number: PCT/JP2014/003806
(87) International publication number: WO 2015/015746

(57) **Abstract**

There is provided a wiring board and a method for manufacturing the wiring board which can prevent an electrical adverse influence attributable to an end surface of a wiring conductor for plating exposed on a side surface of the wiring board, and can also reliably prevent an adverse influence attributable to EMI noise between the inside and the outside of the board main body.

A wiring board 1a including a board main body 2 made of an insulating material and having a front surface 3 and rear surface 4 having a rectangular shape in a planar view and side surfaces 5a, 5b at four sides located between the front surface and the rear surface, and a wiring conductor 8 for plating, an end surface of which is exposed on any side surface 5a or 5b of the board main body 2, wherein the wiring board includes a first insulating layer 11 formed on the side surface 5a, 5b on which the end surface of the wiring conductor 8 for plating is exposed among the side surfaces 5a, 5b of the board main body 2 to cover the end surface of the wiring conductor 8 for plating, and a conductor layer 12 formed on the side surface 5a, 5b of the board main body 2 on which the first insulating layer 11 is formed along a side direction of the side surface 5a, 5b including a surface of the first insulating layer 11, and wherein the conductor layer 12 is electrically connected to a ground layer 10 formed inside the board main body 2.

## Description

### Technical Field

The present invention relates to a wiring board including a board main body made of an insulating material and having a front surface, a rear surface and side surfaces located between the front surface and the rear surface and a wiring conductor for plating, an end surface of which is exposed on the side surface, and can reliably suppress electromagnetic interference (EMI) noise and the like, and a method for manufacturing the same.

### Background Art

In order to prevent an adverse influence attributable to EMI noise, there is proposed a semiconductor package in which a conductor pattern for shielding which is connected conductively to a ground wiring pattern is formed on a side surface of the package by a printing method and the conductor portion exposed on the surface of the package is plated by an electroless plating method or the like (e.g., see Patent Document 1).

According to the semiconductor package, since the conductor pattern for shielding which is connected conductively to the ground wiring pattern is formed on the side surface of the package, the adverse influence attributable to EMI noise can be prevented. However, in the case where an end surface of a wiring conductor for plating is exposed on a side surface of the package, inadvertent short circuit may occur when the conductor pattern for shielding is formed on the side surface including the end surface. Furthermore, since the conductor pattern for shielding is exposed outside, there is a problem that an electrical adverse influence such as inadvertent short circuit may occur between an adjacently disposed package.

Moreover, with miniaturization of a semiconductor package, there is also a problem that an electrical adverse influence may occur since a wiring for signal is disposed in the vicinity of the package side surface.

On the other hand, there is proposed a piezoelectric device in which an electrode terminal for external connection is subjected to electrolytic plating in advance at a stage of multi-piece forming, and an exposed surface of a wiring pattern for plating, which is exposed to an outer surface of the side wall portion of a container body cut and divided into pieces, is covered with an insulating film (e.g., see Patent Document 2).

According to the above piezoelectric device, since the exposed surface of the wiring pattern for plating, which is exposed to an outer surface of the side wall portion of the container body after cutting and dividing, is covered with the insulating film and insulated, an aligning jig or a pressing pin does not inadvertently come into contact with the above wiring pattern for plating. As a result, measurement of electrical properties can be stably performed in a state that the container body is disposed on the aligning jig. However, in the piezoelectric device, there is a problem that the adverse influence attributable to EMI noise or the like cannot be effectively prevented.

### Prior Art Documents

### Patent Documents

Patent Document 1: JP-A-H11-102987 (Pages 1 to 4, Fig. 1)
Patent Document 2: JP-A-2008-141412 (Pages 1 to 8, Figs. 1 to 3)

### Summary of the Invention

### Problems that the Invention is to Solve

A problem of the present invention is to provide a wiring board and a method for manufacturing the same which solves the problems illustrated in the background art, in which metal terminals formed on the front and rear surfaces in each wiring board is subjected to electrolytic plating at a stage of multi-piece forming, and which can prevent an electrical adverse influence attributable to an end surface of a wiring conductor for plating exposed on a side surface of the separately divided wiring board, and can also reliably prevent an adverse influence attributable to EMI noise or the like between the inside and the outside of the board main body.

### Means for Solving the Problems and Advantage of the Invention

In order to solve the problem, the invention is made based on an idea that an insulating layer is formed on a side surface of the board main body on which an end surface of a wiring conductor for plating is exposed to cover the end surface and also a conductor layer for electromagnetic wave shielding is formed along a side direction of the side surface of the board main body including the surface of the insulating layer.

A first wiring board according to the invention (claim 1) is a wiring board including a board main body made of an insulating material and having a front surface and rear surface having a rectangular shape in a planar view and side surfaces at four sides located between the front surface and the rear surface, and a wiring conductor for plating, an end surface of which is exposed on any side surface of the board main body, characterized in that: the wiring board includes a first insulating layer formed on at least the side surface of the board main body on which the end surface of the wiring conductor for plating is exposed among the side surfaces of the board main body to cover the end surface of the wiring conductor for plating, and a conductor layer formed on the side surface of the board main body on which the first insulating layer is formed along a side direction of the side surface including a surface of the first insulating layer, and the conductor layer is electrically connected to a ground layer formed inside the board main body.

Accordingly, since the first insulating layer is formed on at least the side surface of the board main body on which the end surface of the wiring conductor for plating is exposed among the side surfaces of the board main body to cover the end surface of the wiring conductor for plating, electrical connection such as inadvertent short circuit with the outside through the wiring conductor for plating can be prevented. Furthermore, since the conductor layer electrically connected to the ground layer (ground) inside the board main body is formed on the side surface of the board main body on which the first insulating layer is formed along a side direction of the side surface and including the whole surface of the first insulating layer, electromagnetic waves in inside and outside directions of the board main body can be reliably shielded. Accordingly, there can be obtained a wiring board which can reliably prevent an adverse influence attributable to EMI noise that may be generated by the end surface of the wiring conductor for plating exposed on the side surface of the wiring board or the wiring conductor disposed in the vicinity of the side surface of the board main body and an adverse influence attributable to inadvertent electrical connection.

Further, a second wiring board according to the invention (claim 2) is a wiring board including a board main body made of an insulating material and having a front surface and rear surface having a rectangular shape in a planar view and side surfaces at four sides located between the front surface and the rear surface, and a wiring conductor for plating, an end surface of which is exposed on any side surface of the above board main body, characterized in that: the wiring board includes a first insulating layer formed on at least the side surface of the board main body on which the end surface of the wiring conductor for plating is exposed among the side surfaces of the board main body to cover the end surface of the wiring conductor for plating, and a conductor layer formed on the side surface of the board main body on which the first insulating layer is formed along a side direction of the side surface including a surface of the first insulating layer, and the conductor layer is electrically connected to a ground layer formed inside the board main body at a plurality of positions.

Accordingly, in addition to the above effect of the first wiring board, since the conductor layer formed on the side surface of the board main body is electrically connected to the ground layer formed inside the board main body at a plurality of positions, unevenness in electric potential over the whole conductor layer can be suppressed. As a result, the electromagnetic wave shielding in inside and outside directions of the board main body can be made further reliable.

Incidentally, a plurality of positions as mentioned above are two or more positions (e.g., 2, 4, 6, 8 or 10 positions) and intervals between the connecting positions of the conductor layer and the ground layer is desirably equal.

Incidentally, the insulating material constituting the board main body may be any of a ceramic (e.g., alumina, mullite, aluminum nitride, a glass-ceramic, or the like) or a resin (e.g., epoxy-based one, a polyimide, or the like).

Moreover, the first insulating layer and a second insulating layer to be mentioned below are formed by applying an insulating paste containing a resin as a main component on a necessary region by a printing method or a spraying method involving masking and subsequently performing a hardening (curing) treatment. Alternatively, they may be formed by sticking a photosensitive resin film and irradiating it with UV rays.

Furthermore, the conductor layer is formed by applying a conductive paste containing a fine powder of a metal such as Cu, Ag, or Ni and a photosensitive resin on a necessary region by a printing method or a spraying method involving masking or an electrodeposition method and subsequently performing a hardening treatment by ultraviolet (UV) irradiation. Alternatively, the conductor layer may be formed by adhering a thin-film tape made of a metal such as Cu, Ag, or Ni and having an adhesive layer on one surface thereof.

Moreover, in a mode where a single conductor layer continues along side directions of the side surfaces at the four sides of the board main body and along a whole circumference of such four sides, the conductor layer is made conductive with the ground layer on at least one position. On the other hand, in a mode including four conductor layers formed along side directions of each side surface and in a mode including two or more conductor layers, each of the conductor layers are individually conducted with the ground layer.

Furthermore, on the front surface and the rear surface of the board main body, there are formed metal terminals covered with a metal plating film as a surface layer formed by electrolytic plating through the wiring conductor for plating. The metal terminal is an electrode pad for conductive connection to an electronic component to be mounted on the front surface of the board main body or a rear surface conductor layer formed on the rear surface of the board main body and used for conductive connection with a mother board on which the present wiring board is to be mounted, and is, for example, made of Cu, Ag, or the like, and the surface layer thereof is covered with an Ni plating film and an Au plating film.

Additionally, the side direction means a direction along the side surface of the board main body in a planar view, and at the corner portion of adjacent side surfaces, means a direction along each side surface in a planar view.

Further, the invention includes a wiring board (claim 3) in which a second insulating layer is further formed on the side surface of the board main body on which the conductor layer is formed along the side direction of the side surface to cover the whole surface of the conductor layer.

Accordingly, the second insulating layer is further formed on the side surface of the board main body on which the conductor layer is formed along the side direction of the side surface to cover the whole surface of the conductor layer. Therefore, in addition to the prevention of the electrical connection such as the short circuit and the shielding of electromagnetic waves, there can be reliably prevented an adverse influence attributable to inadvertent electrical connection such as short circuit with a wiring board adjacent to the conductor layer, an electronic component mounted on the board, and the like.

Further, the invention includes a wiring board (claim 4) in which, at a corner portion between adjacent two side surfaces, the conductor layers formed respectively on the two side surfaces are directly connected to each other.

Accordingly, since the conductor layers are directly connected at the corner portion between adjacent two or three side surfaces or along the whole side surfaces of four sides of the board main body, an electromagnetic wave generated resulting from the wiring conductor disposed in the vicinity of the side surface of the board main body can be more reliably shielded.

Further, the invention includes a wiring board (claim 5) in which a concave portion that dents toward a central side of the board main body in a planar view is formed between adjacent two side surfaces located on the same side of the board main body along a thickness direction of the front surface and the rear surface or at a corner portion between adjacent two side surfaces of the board main body along the thickness direction of the front surface and the rear surface, a metalized layer formed on a surface of the concave portion is electrically connected to the ground layer, and the conductor layer is continuously formed on the surface of the metalized layer along a side direction of the adjacent two side surfaces.

Accordingly, the concave portion is formed between the adjacent two side surfaces located on the same side of the board main body or at the corner portion between the adjacent two side surfaces, the metalized layer formed on the surface of the concave portion is electrically connected to the ground layer, and the conductor layer is continuously formed on the surface of the metalized layer along the side direction of the adjacent two side surfaces. Therefore, the shielding of the electromagnetic wave by the conductor layer can be easily and reliably performed also in a mode where the metalized layer located on the surface of the concave portion intervenes.

Incidentally, the concave portion includes a mode of approximately one fourth of a circular shape (circular arc shape) and approximately one fourth of an elliptic shape (circular arc shape), a mode of a combination of approximately one fourth of a circular shape (circular arc shape) at a corner side and approximately one fourth of an elliptic shape which extends to both side surface sides thereof, a mode of a chamfer that intersects each of adjacent two side surfaces at a slant of about 45° and in a symmetrical manner, and the like.

Moreover, the metalized layer formed on the surface of the concave portion is formed on the whole surface of the concave portion or at an intermediate position in a thickness direction of the board main body, is made of, for example, Cu, Ag, or the like, and a surface thereof is covered with an Ni plating film and an Au plating film.

Furthermore, it is also possible to be a mode where the whole surface of the conductor layer formed on the surface of the metalized layer located on the surface of the concave portion is further covered with the second insulating layer.

Further, the invention includes a wiring board (claim 6) in which the conductor layer and the second insulating layer are formed on the side surface of the board main body from which the end surface of the wiring conductor for plating is not exposed along a side direction of the side surface.

Accordingly, even on the side surface of the board main body from which the end surface of the wiring conductor for plating is not exposed, the shielding of an unnecessary electromagnetic wave from the wiring conductor disposed in the vicinity of the side surface can be performed and also an electrical adverse influence such as inadvertent short circuit attributable to the conductor layer can be prevented.

Meanwhile, a method for manufacturing a wiring board according to the invention (claim 7) is a method for manufacturing a wiring board comprising a board main body made of an insulating material and having a front surface and rear surface having a rectangular shape in a planar view and side surfaces at four sides located between the front surface and the rear surface, and a wiring conductor for plating, an end surface of which is exposed at any side surface of the board main body, characterized in that: the method includes: a step of forming a first insulating layer on at least the side surface of the board main body on which the end surface of the wiring conductor for plating is exposed among the side surfaces of the board main body to cover the end surface of the wiring conductor for plating, and a step of forming a conductor layer on the side surface of the board main body on which the first insulating layer is formed along a side direction of the side surface including a surface of the first insulating layer, and the conductor layer is electrically connected to a ground layer formed inside the board main body.

Accordingly, the wiring board includes the first insulating layer formed on the side surface at which the end surface of the wiring conductor for plating is exposed to cover the end surface of the wiring conductor for plating and the conductor layer connected to the internal ground layer and formed on the side surface of the board main body on which the first insulating layer is formed along a side direction of the side surface and including the whole surface of the first insulating layer. Thus, there can be reliably manufactured the wiring board which can reliably prevent an adverse influence attributable to electrical connection resulting from the end surface of the wiring conductor for plating exposed at the side surface of the wiring board and an adverse influence attributable to EMI noise.

Incidentally, each step of the above manufacturing method is performed after removing a frame portion (discarding margin, commonly known as an edge portion) of a peripheral portion from a large-sized base board for multi-piece forming made of a ceramic or a resin and dividing a central board region into individual wiring boards. The individually divided wiring board, as mentioned above, includes in advance a board main body made of an insulating material and having a front surface and rear surface having a rectangular shape in a planar view and side surfaces at four sides located between the front surface and the rear surface, and a wiring conductor for plating, an end surface of which is exposed at any side surface of the board main body.

Moreover, it is recommended that the conductor layer is electrically connected to the ground layer formed inside the board main body at a plurality of positions.

Further, the invention includes a method for manufacturing a wiring board (claim 8) in which the method further includes a step of forming a second insulating layer on the side surface of the board main body on which the conductor layer is formed along the side direction of the side surface to cover the whole surface of the conductor layer.

Accordingly, there can be reliably manufactured a wiring board wherein the second insulating layer is further formed on the side surface of the board main body on which the conductor layer is formed and along the side direction of the side surface to cover the whole surface of the conductor layer. As a result, there can be manufactured a wiring board which can reliably prevent an adverse influence attributable to an electrical connection of both of the end surface of the wiring conductor for plating and the conductor layer and an adverse influence attributable to EMI noise.

Further, the invention includes a method for manufacturing a wiring board (claim 9) in which the step of forming the conductor layer includes a step of forming the conductor layer continuously on a surface of a metalized layer along a side direction of adjacent two side surfaces, a concave portion, which dents toward a central side of the board main body in a planar view, being formed between the adjacent two side surfaces located on the same side of the board main body along a thickness direction of the front surface and the rear surface or at a corner portion between the adjacent two side surfaces of the board main body along the thickness direction of the front surface and the rear surface, and the metalized layer formed on the surface of the concave portion being electrically connected to the ground layer.

Accordingly, through the metalized layer formed on the surface of the concave portion located between the adjacent two side surfaces located at the same side of the board main body or at the corner portion between adjacent two side surfaces, the conductor layer formed along a side direction of each side surface and the ground layer inside the board main body can be easily and reliably conductively connected. Therefore, it becomes possible to manufacture a wiring board excellent in electromagnetic wave-shielding properties in various practical modes.

Further, the invention includes a method for manufacturing a wiring board (claim 10) in which a step of forming the conducting layer and a second insulating layer along a side direction of the side surface is performed on the side surface of the board main body from which the end surface of the wiring conductor for plating is not exposed.

Accordingly, there can be reliably manufactured a wiring board which can perform the shielding of an unnecessary electromagnetic wave by the conductor layer and can prevent an electrical adverse influence such as short circuit resulting from the conductor layer, even at the side surface of the board main body on which the end surface of the wiring conductor for plating is not exposed.

### Brief Description of the Drawings

Fig. 1 is a perspective view showing one mode of the wiring board according to the invention and including a cross-section in part.
Fig. 2 is a horizontal sectional view along an arrow direction of an X-X line in Fig. 1.
Fig. 3 is a partial vertical sectional view along an arrow direction of a Y-Y line in Fig. 1.
Fig. 4 is a horizontal sectional view of an application mode of the above wiring board, the view being similar to Fig. 2.
Fig. 5 is a perspective view showing a different mode of the wiring board and including a cross-section in part.
Fig. 6 is a partial horizontal sectional view of the above wiring board, the view being similar to the above.
Fig. 7 shows schematic diagrams ((A), (B)) showing one manufacturing step for obtaining above each wiring board.
Fig. 8 shows schematic diagrams ((A), (B)) showing a manufacturing step subsequent to Fig. 7.
Fig. 9 shows schematic diagrams ((A), (B)) showing a manufacturing step subsequent to Fig. 8.
Fig. 10 is a partial vertical sectional view showing the wiring board obtained by the above manufacturing steps.
Fig. 11 is a partial horizontal sectional view showing the vicinity of one mode of the corner portion in the above wiring board.
Fig. 12 is a partial horizontal sectional view showing the vicinity of a different mode of the corner portion.
Fig. 13 is a partial horizontal sectional view showing the vicinity of a further different mode of the corner portion.
Fig. 14 is a perspective view showing a further different mode of the wiring board and including a cross-section in part.
Fig. 15 is a partial horizontal sectional view of the above wiring board, the view being similar to the above.
Fig. 16 is a partial horizontal sectional view showing the vicinity of the concave portion between two side surfaces at the same side.

### Modes for Carrying Out the Invention

The following will explain modes for carrying out the present invention.

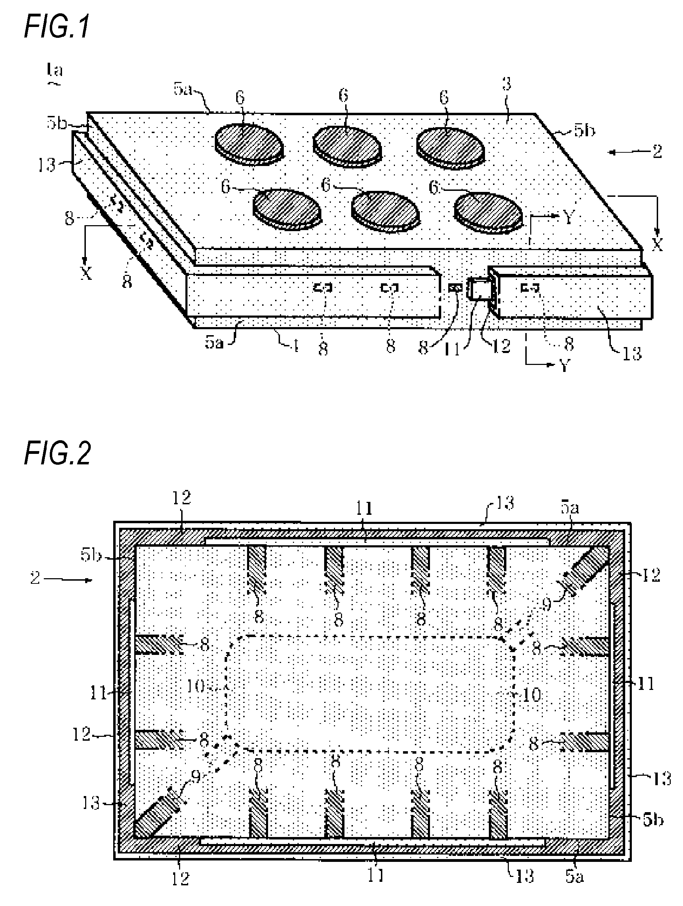

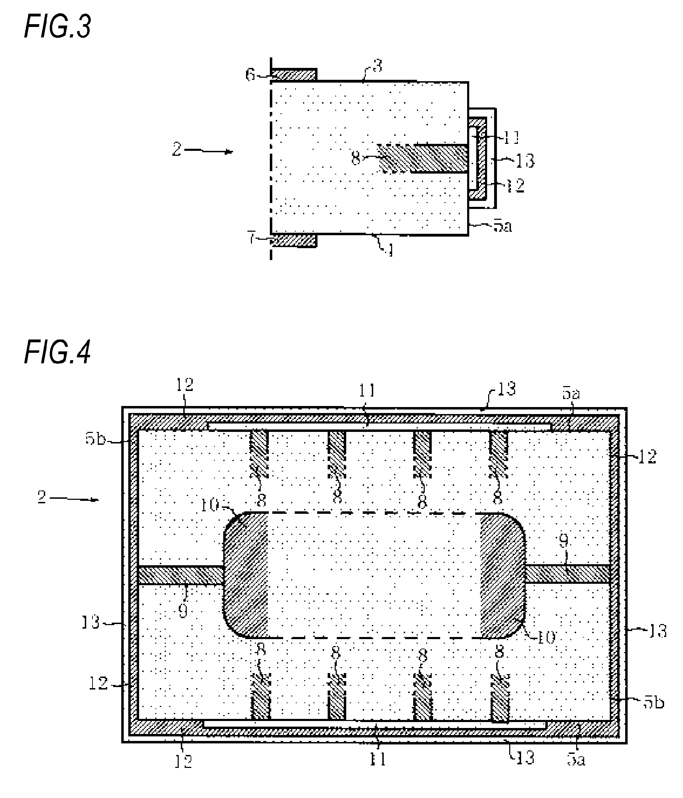

Fig. 1 shows one mode of a wiring board 1 according to the invention and including a cross-section cut in part, Fig. 2 is a horizontal sectional view along an arrow direction of an X-X line in Fig. 1, and Fig. 3 is a partial vertical sectional view along an arrow direction of a Y-Y line in Fig. 1.

The wiring board 1 comprises, as shown in Figs. 1 to 3, a board main body 2 that is a plate shape as a whole and shows a rectangular parallelepiped, a plurality of metal terminals (electrode pads) 6 formed on a front surface 3 of the board main body 2, and a plurality of metal terminals (rear surface conductor layers) 7 formed on a rear surface 4 of the board main body 2. The board main body 2 is made of a laminated body obtained by stacking insulating materials made of a plurality of ceramic layers or a plurality of resin layers, and a flat (plate-shaped) ground layer 10 in a planar view is formed between any layers. In the board main body 2, a pair of opposing long-side side surfaces 5a and a pair of opposing short-side side surfaces 5b are individually located between the rectangular front surface 3 and rear surface 4 in a planar view.

Incidentally, the ceramic layer contains, for example, alumina (insulating material) as a main component and the resin layer contains, for example, an epoxy resin (insulating material) as a main component.

As shown in Figs. 1 to 3, on the side surfaces 5a, 5b at four sides, in a mode of multi-piece forming, four pieces or two pieces of the end surfaces of the wiring conductors 8 for plating, which are for covering the surfaces of the metal terminals 6 and 7 with an Ni plating film and an Au plating film by electrolytic plating, are exposed per one side surface. The wiring conductor 8 for plating is used, in a large-sized ceramic-made or resin-made base board for multi-piece forming, for transmitting an electric current for plating, which is supplied from the outside penetrating between adjacent wiring boards 1a and 1a or between a peripheral frame-shaped edge portion (discarding margin) and the wiring board 1a adjacent thereto, to each of the metal terminals 6, 7 of each wiring board 1. Moreover, wiring conductors not shown in the figure are disposed in the vicinity of the side surfaces 5a, 5b of the board main body 2.

As shown in Figs. 1 to 3, on each of the side surfaces 5a, 5b on which a plurality of the end surfaces of the wiring conductors 8 for plating are exposed, a first insulating layer 11 mainly made of a resin component is formed so as to cover the portion at which each end surface of the wiring conductor 8 is exposed, and a conductor layer 12 made of a conductive resin is formed along the whole circumference of the four sides, to cover the whole surface of the first insulating layer 11 and along the whole length in a side (longitudinal) direction of each side surface 5a, 5b. Furthermore, a second insulating layer 13 mainly made of a resin component is formed along the whole circumference of the four sides, to cover the whole surface of the conductor layer 12 and along the whole length in a side (longitudinal) direction of each side surface 5a, 5b.

As shown in Fig. 2, a pair (plurality) of connection wirings 9 is diagonally formed from the vicinity of a corner between adjacent side surfaces 5a, 5b of the conductor layer 12 toward the ground layer 10 located in the board main body 2. Therefore, the conductor layers 12 of individual side surfaces 5a, 5b are directly connected to each other and also are electrically connected to the ground layer 10 at a plurality of positions.

Incidentally, the end surface of the wiring conductor 8 for plating has a width of about 75 µm and a length of about 30 µm and the first and second insulating layers 11, 13 and the conductor layer 12 each have a thickness of about 100 µm or less (about 60 to 90 µm). The first and second insulating layers 11, 13 are, for example, made of a resin such as an epoxy resin, and the conductor layer 12 is mainly made of a fine powder of Cu, Ni, or Ag, a photosensitive resin (e.g., a cinnamic acid ester), and the like.

Moreover, the metal terminals 6, 7, the wiring conductor 8 for plating, the connection wiring 9, and the ground layer 10 are made of W, Mo, Cu, or Ag in the case where the board main body 2 is made of a ceramic and are made of Cu or Ag in the case where the board main body 2 is made of a resin.

Furthermore, it is not necessary to form the conductor layer 12 over the whole circumference of the side surfaces 5a, 5b at four sides of the board main body 2 and may be divided into two or more according to individual portions electrically connected to the ground layer 10, and the second insulating layer 13 may be divided into the same number depending on the portions.

Additionally, the number of the connection positions of the conductor layer 12 and the ground layer 10 by the connection wiring 9 may be three or more and the intervals of the positions is desirably equal irrespective of the number of the positions.

Fig. 4 is a horizontal sectional view showing an application mode of the wiring board 1a, the view being similar to Fig. 2. In such a mode, a plurality of the end surfaces of the wiring conductors 8 for plating are exposed in a similar manner to the above on the long-side side surface 5a of the board main body 2 but any end surface of the wiring conductor 8 for plating is not exposed on the short-side side surface 5b. Therefore, on the pair of the side surfaces 5a, the first insulating layer 11, the conductor layer 12, and the second insulating layer 13 are formed in a similar manner to the above but, on the pair of the side surfaces 5b, the conductor layer 12 as above and the second insulating layer 13 covering the whole surface thereof are only formed.

Incidentally, as shown in Fig. 4, the conductor layer 12 and the ground layer 10 are connected through a pair (plurality) of the connection wirings 9 provided between a central portion of the conductor layer 12 formed on the short-side side surface 5b and a central portion of a short side of the flat (rectangular) ground layer 10.

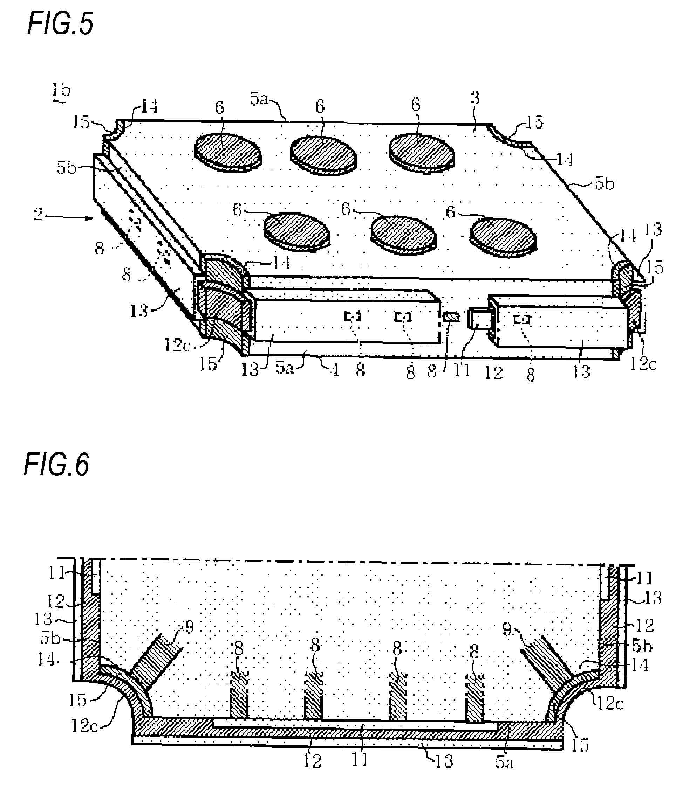

Fig. 5 is a perspective view showing a different mode of the wiring board 1b and including a cross-section cut in part, and Fig. 6 is nearly half of a horizontal sectional view of the wiring board 1b.

As shown in Figs. 5 and 6, the wiring board 1b has a board main body 2 similar to the above, and a circular arc-shaped concave portion 14 which is about one fourth of a circular shape in a planar view and dents toward the central side of the board main body 2 is formed at each corner portion between adjacent side surfaces 5a, 5b in the board main body 2, and a metalized layer 15 having an almost similar shape in a planar view is further formed along the surface of the concave portion 14. The metalized layer 15 is electrically connected to the ground layer 10 through the connection wiring 9 at each corner portion. The metalized layer 15 is also made of W, Mo, Cu, or Ag in the case where the board main body 2 is made of a ceramic and is made of Cu or Ag in the case where the board main body 2 is made of a resin.

As shown in Figs. 5 and 6, on each of the side surfaces 5a, 5b of the board main body 2, four pieces or two pieces of the end surfaces of the wiring conductors 8 for plating are exposed per one side surface. Therefore, on each of the side surfaces 5a, 5b, the first insulating layer 11 is formed so as to cover the end surface of each wiring conductor 8 for plating, and the conductor layer 12 is formed so as to cover the whole surface of the first insulating layer 11. On the surface of the metalized layer 15 of the concave portion 14 at each corner, a conductor layer 12c is formed along a side direction of each of the side surfaces 5a, 5b so as to continue to the adjacent conductor layer 12 and they continue along the whole circumference of the side surfaces 5a, 5b at four sides of the board main body 2. Furthermore, as shown in Fig. 6, the conductor layer 12 and the ground layer 10 are electrically connected through the connection wirings 9 at 4 positions including the metalized layer 15 of the concave portion 14 at each corner.

Incidentally, the second insulating layer 13 may be further formed so as to cover the whole surface of the conductor layer 12c formed on the surface of the metalized layer 15 of the concave portion 14.

Moreover, in the case where the end surface of the wiring conductor 8 for plating is not exposed on the side surface 5b of the board main body 2, only the conductor layer 12 and the second insulating layer may be formed in a similar manner to the above.

According to the above wiring boards 1a, 1b, the end surfaces of the wiring conductors 8 for plating exposed on each of the side surfaces 5a, 5b of the board main body 2 are all covered with the first insulating layer 11, the conductor layer 12 is formed so as to cover the whole surface of the first insulating layer 11, and the second insulating layer 13 is formed so as to cover the whole surface of the conductor layer 12. Furthermore, the conductor layer 12 is electrically connected to the ground layer 10 through the connection wiring 9 or through the metalized layer 15 and the connection wiring 9. Therefore, there can be prevented electric connection such as inadvertent short circuit with the outside resulting from the intervention of the wiring conductor 8 for plating, and also electromagnetic waves at the inside and the outside of the board main body 2 can be reliably shielded by the conductor layer 12, so that an adverse influence attributable to EMI noise can be reliably prevented. Furthermore, an adverse influence attributable to electric connection such as short circuit with a wiring board, an electronic component, and the like adjacent to the conductor layer 12 can be reliably prevented by the second insulating layer 13. Additionally, since the conductor layer 12 is electrically connected to the ground layer 10 through two (plurality) or more pieces of connection wirings 9, unevenness in electric potential in the whole conductor layer 12 is suppressed and thereby electromagnetic waves in inside and outside directions of the board main body 2 can be more reliably shielded.

The following will explain the method for manufacturing the wiring boards 1a and 1b.

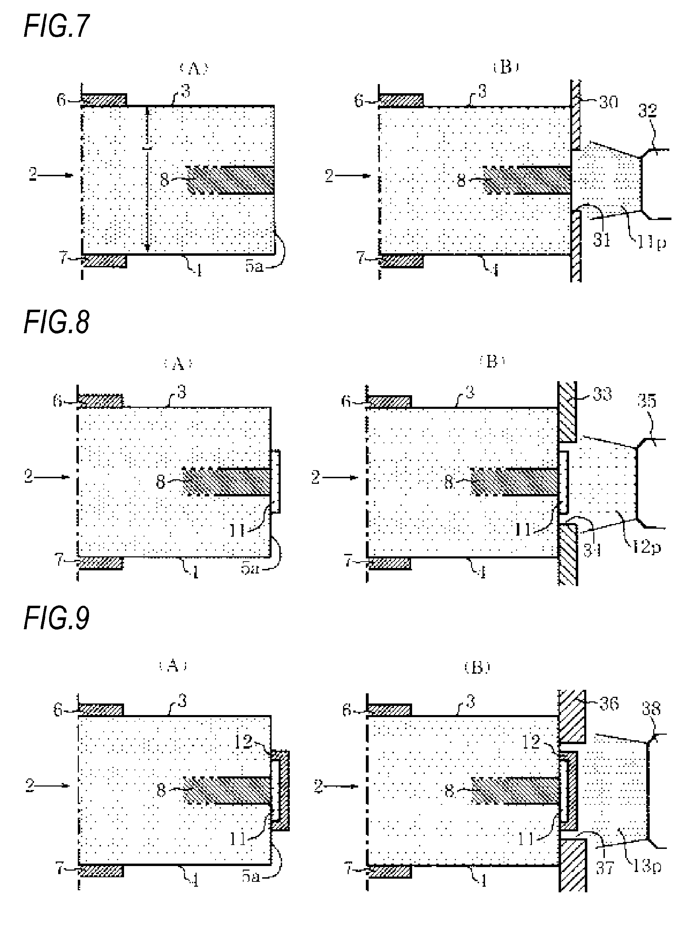

As shown in Fig. 7(A), in advance, in the mode of multi-piece forming, after necessary electrolytic Ni plating or electrolytic Au plating is performed on each surface of the metal terminals 6, 7 formed on the front surface 3 and the rear surface 4 of the board main body 2 using the wiring conductors 8 for plating, individually cut and divided wiring boards 1a, 1b are prepared. Incidentally, the thickness t between the front surface 3 and the rear surface 4 of the board main body 2 is about 1 mm or less.

First, as exemplified in Fig. 7(B), a mask 30 made of a sheet metal having a long and narrow slit-like pattern hole 31 was mounted onto the side surface 5a of the board main body 2 along front and back directions of the figure shown and, in such a state, an insulating paste 11p made of an epoxy resin was sprayed from a nozzle 32. As a result, individual end surfaces of a plurality of the wiring conductors 8 for plating along the front and back directions of the figure shown were covered with a band-like resin film made of the insulating paste 11p of the epoxy resin. After an excessive portion of the resin film was cut and removed by means of a knife or the like, the resin film was heated to a predetermined temperature to perform a hardening treatment (curing treatment). As a result, as shown in Fig. 8(A), the first insulating layer 11 covering individual end surfaces of the wiring conductors 8 for plating was formed on the side surface 5a of the board main body 2.

Then, as exemplified in Fig. 8(B), a mask 33 made of a sheet metal having a slightly long and narrow slit-like pattern hole 34 was mounted onto the side surface 5a of the board main body 2 along front and back directions of the figure shown and, in such a state, a conductive paste 12p containing a fine powder of Ag having an average particle size of about 1 to several µm, a photosensitive resin, and a solvent was sprayed from a nozzle 35.

As a result, a band-like conductive paste made of the conductive paste 12p along the front and back directions of the figure shown was applied so as to cover the whole surface of the first insulating layer 11. Furthermore, after an excessive portion of the conductive paste was cut and removed by means of a knife or the like, the conductive paste is irradiated with UV rays to perform a hardening treatment of the photosensitive resin. Thereby, as shown in Fig. 9(A), there was formed the conductor layer 12 which covers the whole surface of the first insulating layer 11.

Next, as exemplified in Fig. 9(B), a mask 36 made of a sheet metal having slit-like pattern hole 37 wider than that in each of the above modes was mounted onto the side surface 5a of the board main body 2 along the front and back directions of the figure shown and, in such a state, an insulating paste 13p made of an epoxy resin was sprayed from a nozzle 38. Subsequently, a cut-off treatment and a hardening treatment similar to the above were performed.

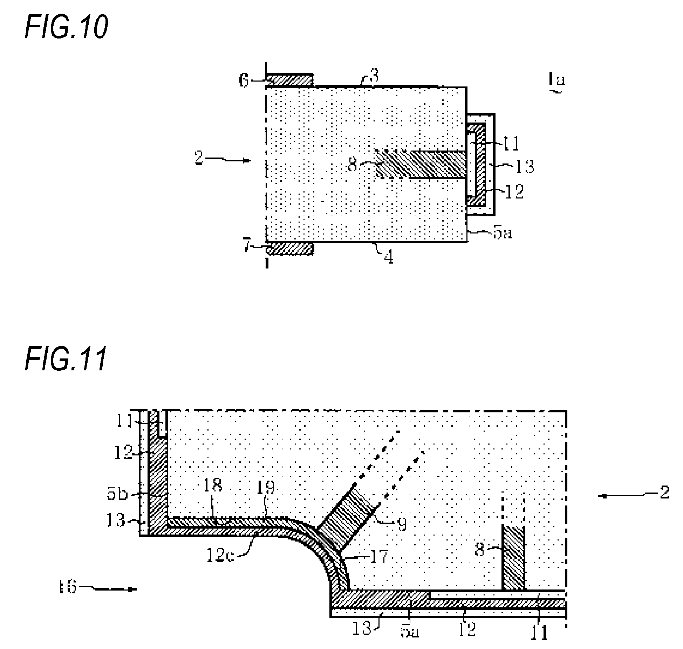

As a result, as shown in Fig. 10, the end surfaces of the wiring conductors 8 for plating which were exposed on each of the side surfaces 5a, 5b of the board main body 2 were all covered with the first insulating layer 11, the conductor layer 12 was formed so as to cover the whole surface of the first insulating layer 11, and the second insulating layer 13 was formed so as to cover the whole surface of the conductor layer 12. As a result, it was able to obtain the wiring boards 1a and 1b as mentioned above.

Incidentally, during the above steps, one pair of or four pieces of connection wirings 9 separately formed were formed so as to connect the conductor layer 12 and the ground layer 10.

According to the manufacturing method of the wiring boards 1a and 1b, on the side surfaces 5a, 5b of the board main body 2, the first insulating layer 11 was formed to cover the end surface of the wiring conductor 8 for plating, the conductor layer 12 which was formed along a side direction of the side surfaces 5a, 5b including the whole surface of the first insulating layer 11 and was connected to the inside ground layer 10 was formed, and also the second insulating layer 13 was formed to cover the whole surface of the conductor layer 12. As a result, it was able to reliably manufacture the wiring boards 1a, 1b capable of reliably preventing an electric adverse influence attributable to the end surface of the wiring conductor 8 for plating which was exposed on the side surface 5a, 5b of the wiring board 1a, 1b and an adverse influence attributable to EMI noise or the like.

Fig. 11 is a partial horizontal sectional view showing the vicinity of a different mode of concave portion 16 of the board main body 2 of the wiring board 1b. As shown in Fig. 11, in the board main body 2, the concave portion 16 which is made of a circular-arc portion 17 and a straight-line portion 18 in a planar view, shows about one fourth of an elliptic shape in a planar view, and dents toward the central side of the board main body 2 is present at each corner portion between adjacent side surfaces 5a, 5b and a metalized layer 19 similar to the above is formed on the surface of the concave portion 16. The metalized layer 19 is electrically connected to the ground layer 10 through the connection wirings 9 formed at four positions.

As shown in Fig. 11, on each of the side surfaces 5a, 5b adjacent across the concave portion 16, the first insulating layer 11 covering the end surface of the wiring conductor 8 for plating, the conductor layer 12 covering the whole surface of the first insulating layer 11, and the second insulating layer 13 covering the whole surface of the conductor layer 12 are formed in a similar manner to the above. On the surface of the metalized layer 19 formed in an almost even thickness along the surface of the concave portion 16, a conductor layer 12c is formed so as to continue along the side direction of each of the side surfaces 5a, 5b. As a result, the conductor layers 12 and 12c continue along the whole circumference of the side surfaces 5a, 5b at four sides of the board main body 2.

Incidentally, the second insulating layer 13 may be further formed so as to cover the whole surface of the conductor layer 12c formed on the surface of the metalized layer 19 of the concave portion 19.

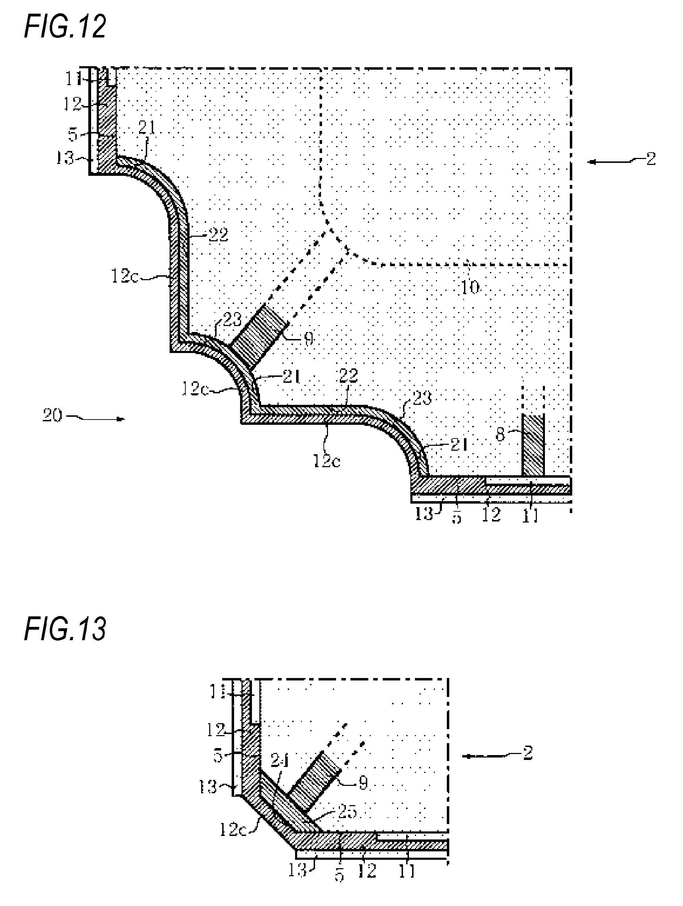

Fig. 12 is a partial horizontal sectional view showing the vicinity of a still different mode of concave portion 20 of the board main body 2 of the wiring board 1b. As shown in Fig. 12, in the board main body 2 having a square shape in a planar view, at each corner portion between adjacent side surfaces 5, 5, there is formed the concave portion 20 having a different shape in a planar view, the concave portion being made of a pair of circular-arc portions 21 adjacent to individual side surfaces 5, 5, a pair of linear portions 22 which extend from the arc portions parallel to individual side surfaces 5, 5 and are orthogonal to each other, and an intermediate circular-arc portion 21 located between the linear portions and denting toward the central side of the board main body 2. On the surface of the concave portion 20, a metalized layer 23 similar to the above is formed in almost even thickness along the surface of the concave portion 20. The metalized layer 23 is also electrically connected to the ground layer 10 through four connection wirings 9 as shown in the figure.

As shown in Fig. 12, on each of the side surfaces 5, 5 adjacent across the concave portion 20, the first insulating layer 11 covering the end surface of the wiring conductor 8 for plating, the conductor layer 12 covering the whole surface of the first insulating layer 11, and the second insulating layer 13 covering the whole surface of the conductor layer 12 are formed in a similar manner to the above. On the surface of the metalized layer 23 formed along the surface of the concave portion 20, the conductor layer 12c is formed so as to continue along a side direction of each of the side surfaces 5, 5. As a result, the conductor layers 12, 12c continue along the whole circumference of the side surfaces 5a, 5b at four sides of the board main body 2.

Incidentally, the second insulating layer 13 may be further formed so as to cover the whole surface of the conductor layer 12c formed on the surface of the metalized layer 23 of the concave portion 20.

Fig. 13 is a partial horizontal sectional view showing the vicinity of a different mode of concave portion 25 in the board main body 2 having a square shape in a planar view of the wiring board 1b. As shown in Fig. 13, in the board main body 2, at each corner portion between the adjacent side surfaces 5, 5, there is formed a chamfer-like concave portion 24 which intersects the side surfaces 5, 5 at about 45° and in a symmetrical manner and dents toward the central side of the board main body 2. On the surface of the concave portion 24, a metalized layer 25 similar to the above is formed along the surface of the concave portion 24. The metalized layer 25 is also electrically connected to the ground layer 10 similar to the above through four connection wirings 9 as shown in the figure.

As shown in Fig. 13, on each of the side surfaces 5, 5 adjacent across the concave portion 24, the first insulating layer 11 covering the end surface of the wiring conductor 8 for plating, the conductor layer 12 covering the whole surface of the first insulating layer 11, and the second insulating layer 13 covering the whole surface of the conductor layer 12 are formed in a similar manner to the above. On the surface of the metalized layer 25 formed along the surface of the concave portion 24, the conductor layer 12c is formed so as to continue to the conductor layer 12 of each of the side surfaces 5, 5. As a result, the conductor layers 12, 12c continue along the whole circumference of the side surfaces 5, 5 at four sides of the board main body 2.

Incidentally, the second insulating layer 13 may be further formed so as to cover the whole surface of the conductor layer 12c formed on the surface of the metalized layer 25 of the concave portion 24.

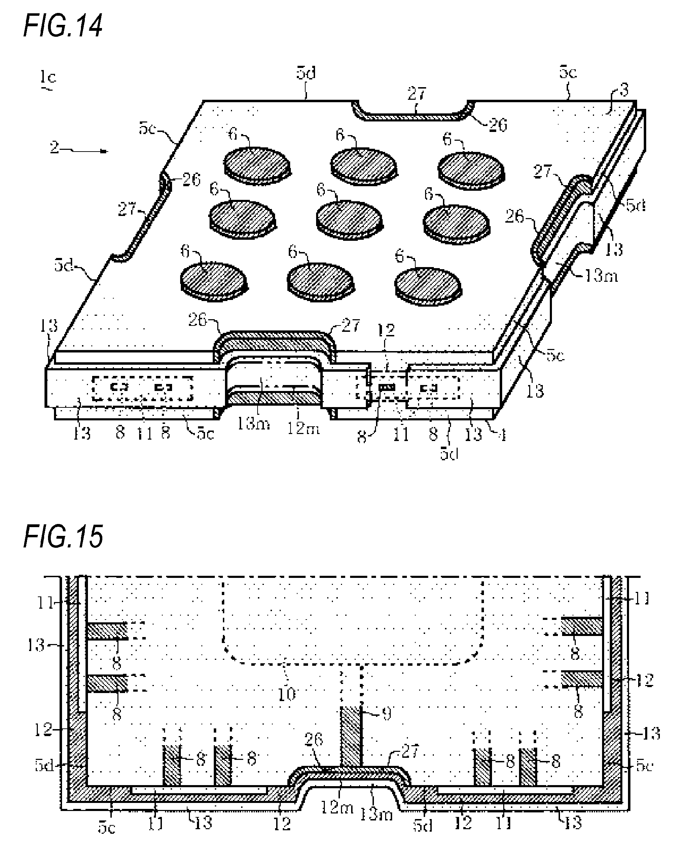

Fig. 14 is a perspective view showing a further different mode of wiring board 1c and including a cutout cross-section in part and Fig. 15 is nearly half of a horizontal sectional view in the wiring board 1c.

As shown in Figs. 14 and 15, such a wiring board 1c is made of a ceramic or a resin similar to the above and there are located the board main body 2 having a plate shape as a whole and having front surface 3 and rear surface 4 showing a substantially square shape in a planar view and two side surfaces 5c, 5d across a concave portion 26 located in the vicinity of the middle and showing an approximately one half of an elliptic shape in a planar view at each of four sides between the front surface 3 and the rear surface 4.

On each of the side surfaces 5c, 5d, two end surfaces of the wiring conductors 8 for plating are exposed on each side surface. Therefore, on each of the side surfaces 5c, 5d, the first insulating layer 11 is formed at each position at which the two end surfaces of the wiring conductors 8 for plating are covered and the conductor layer 12 is formed so as to cover the whole surface of the first insulating layer 11. The conductor layer 12 is continuously formed over the adjacent two side surfaces 5c and 5d even at the corner portions of the four corners. Furthermore, the second insulating layer 13 is continuously formed on the side surfaces 5c and 5d and at these corner portions so as to cover the whole surface of the conductor layer 12.

As shown in Figs. 14 and 15, on the surface of each of the concave portions 26 located between the side surfaces 5c, 5d configuring the same side in a planar view of the board main body 2, a metalized layer 27 is formed in almost even thickness and over the whole surface. The metalized layer 27 is electrically connected to the ground layer 10 in the board main body 2 through four pieces (plurality) of connection wirings 9. On the surface of the metalized layer 27 on each concave portion 26, there are formed a conductor layer 12m and a second insulating layer 13m which continue to the adjacent conductor layer 12 and the second insulating layer 13 on the side surfaces 5c, 5d.

Namely, as exemplified in Fig. 14, the conductor layers 12, 12m and the second insulating layers 13, 13m are continuously formed along the whole circumference of the metalized layer 27 formed on the concave portions 26 and each of the side surfaces 5c, 5d located at four sides of the board main body 2.

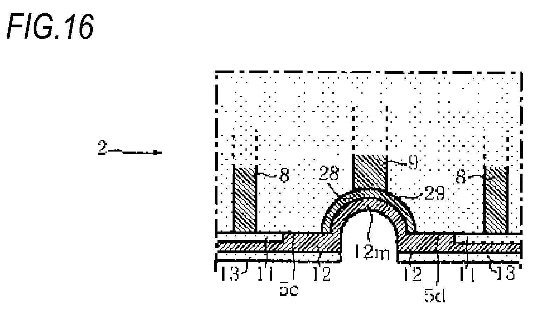

Fig. 16 is a partial horizontal sectional view showing the vicinity of a different mode of concave portion 28 to be applied to the wiring board 1c. As shown in the figure, the concave portion 28 having a substantially semicircular shape in a planar view and the side surfaces 5c, 5d across the concave portion 28 are located on the same side of the board main body 2. On the surface of the concave portion 28, a metalized layer 29 showing a substantially semicylindrical shape is formed, and the metalized layer 29 is also electrically connected to the ground layer 10 through the connection wiring 9.

Moreover, on a pair of the side surfaces 5c, 5d across the concave portion 28, the first insulating layer 11 is formed so as to cover the end surface of the wiring conductor 8 for plating exposed on the side surfaces, and the conductor layer 12 and the second insulating layer 13 are formed so as to cover the whole surface of the first insulating layer 11. Furthermore, on the surface of the metalized layer 29, there is formed the conductor layer 12m which continues to individual conductor layers 12 extending from the side surfaces 5c, 5d at both edge portions and has a semicircular shape in a planar view. Incidentally, so as to cover the conductor layer 12m formed on the surface of the metalized layer 29, the second insulating layer 13 may be formed so as to continue from the side surfaces 5c, 5d in the concave portion 28.

Also by the wiring board 1c as above, electrical connection such as inadvertent short circuit with the outside resulting from the wiring conductor 8 for plating can be prevented and electromagnetic waves at the inside and the outside of the board main body 2 can be reliably shielded by the conductor layer 12, so that an adverse influence attributable to EMI noise or the like can be reliably prevented. Furthermore, an adverse influence attributable to electrical connection such as short circuit with the wiring board, an electronic component, and the like adjacent to the conductor layer 12 can be also reliably prevented by the second insulating layer 13.

Incidentally, on the flat surface of the board main body 2, the concave portion provided at the middle of the same side may have a substantially V-shape in a planar view and, on the surface of the metalized layer formed along the surface of the V-shape, there may be formed at least the conductor layer 12m which continues to the conductor layers 12 extending from the both side surfaces across the concave portion at both edge portions. Furthermore, it is also possible to be a mode where the second insulating layer 13 is formed also in the concave portion so as to cover the whole surface of the conductor layer 12m.

The invention should not be construed as being limited to individual modes as explained above.

For example, the board main body may be a mode where it has a cavity opened on at least one of the front surface and the rear surface thereof. Alternatively, the board main body may be a mode where it has a through hole penetrating between the front surface and the rear surface thereof.

Moreover, the first insulating layer and the second insulating layer may be formed by sticking a thin resin tape to the side surface 5 or the like of the board main body 2.

Furthermore, the conductor layer may be formed by forming a conductive resin on a predetermined position by a printing method or a spraying method and subsequently finishing the resin into predetermined thickness by an electrodeposition method. Alternatively, the conductor layer may be formed by sticking a thin metal tape.

Additionally, the conductor layer and the second insulating layer may be formed by preparing a composite tape through lamination of the above two kinds of tapes beforehand so as to cover three surfaces of the former in cross-section and sticking the composite tape on the side surface 5 and the like of the board main body 2.

### Industrial Applicability

According to the present invention, there can be reliably provided a wiring board and a method for manufacturing the same, which prevents an electrical adverse influence attributable to an end surface of a wiring conductor for plating exposed on a side surface of the wiring board and can also reliably prevent an adverse influence attributable to EMI noise or the like between the inside and the outside of the board main body.

### Description of Reference Numerals and Signs

- 1a to 1c: Wiring board
- 2: Board main body
- 3: Front surface
- 4: Rear surface
- 5, 5a to 5d: Side surface
- 8: Wiring conductor for plating
- 9: Connection wiring
- 10: Ground layer
- 11: First insulating layer
- 12, 12c, 12m: Conductor layer
- 13, 13m: Second insulating layer
- 14, 16, 20, 24, 26, 28: Concave portion
- 15, 19, 23, 25, 27, 29: Metalized layer

## Claims

1. A wiring board comprising:
a board main body made of an insulating material and having a front surface and rear surface having a rectangular shape in a planar view and side surfaces at four sides located between the front surface and the rear surface; and
a wiring conductor for plating, an end surface of which is exposed on any side surface of the board main body,
**characterized in that**:
the wiring board includes a first insulating layer formed on at least the side surface of the board main body on which the end surface of the wiring conductor for plating is exposed among the side surfaces of the board main body to cover the end surface of the wiring conductor for plating, and a conductor layer formed on the side surface of the board main body on which the first insulating layer is formed along a side direction of the side surface including a surface of the first insulating layer, and
the conductor layer is electrically connected to a ground layer formed inside the board main body.

2. A wiring board comprising:
a board main body made of an insulating material and having a front surface and rear surface having a rectangular shape in a planar view and side surfaces at four sides located between the front surface and the rear surface, and
a wiring conductor for plating, an end surface of which is exposed on any side surface of the above board main body,
**characterized in that**:
the wiring board includes a first insulating layer formed on at least the side surface of the board main body on which the end surface of the wiring conductor for plating is exposed among the side surfaces of the board main body to cover the end surface of the wiring conductor for plating, and a conductor layer formed on the side surface of the board main body on which the first insulating layer is formed along a side direction of the side surface including a surface of the first insulating layer, and
the conductor layer is electrically connected to a ground layer formed inside the board main body at a plurality of positions.

3. The wiring board according to claim 1 or 2,
**characterized in that**:
a second insulating layer is further formed on the side surface of the board main body on which the conductor layer is formed along the side direction of the side surface to cover the whole surface of the conductor layer.

4. The wiring board according to any one of claims 1 to 3,
**characterized in that**:
at a corner portion between adjacent two side surfaces, the conductor layers formed respectively on the two side surfaces are directly connected to each other.

5. The wiring board according to any one of claims 1 to 4,
**characterized in that**:
a concave portion that dents toward a central side of the board main body in a planar view is formed between adjacent two side surfaces located on the same side of the board main body along a thickness direction of the front surface and the rear surface or at a corner portion between adjacent two side surfaces of the board main body along the thickness direction of the front surface and the rear surface, a metalized layer formed on a surface of the concave portion is electrically connected to the ground layer, and the conductor layer is continuously formed on the surface of the metalized layer along a side direction of the adjacent two side surfaces.

6. The wiring board according to any one of claims 3 to 5,
**characterized in that**:
the conductor layer and the second insulating layer are formed on the side surface of the board main body from which the end surface of the wiring conductor for plating is not exposed along a side direction of the side surface.

7. A method for manufacturing a wiring board comprising a board main body made of an insulating material and having a front surface and rear surface having a rectangular shape in a planar view and side surfaces at four sides located between the front surface and the rear surface, and a wiring conductor for plating, an end surface of which is exposed at any side surface of the board main body,
**characterized in that**:
the method comprises:
a step of forming a first insulating layer on at least the side surface of the board main body on which the end surface of the wiring conductor for plating is exposed among the side surfaces of the board main body to cover the end surface of the wiring conductor for plating, and
a step of forming a conductor layer on the side surface of the board main body on which the first insulating layer is formed along a side direction of the side surface including a surface of the first insulating layer, and
the conductor layer is electrically connected to a ground layer formed inside the board main body.

8. The method for manufacturing a wiring board according to claim 7,
**characterized in that**:
the method further comprises a step of forming a second insulating layer on the side surface of the board main body on which the conductor layer is formed along the side direction of the side surface to cover the whole surface of the conductor layer.

9. The method for manufacturing a wiring board according to claim 7 or 8,
**characterized in that**:
the step of forming the conductor layer includes a step of forming the conductor layer continuously on a surface of a metalized layer along a side direction of adjacent two side surfaces, a concave portion, which dents toward a central side of the board main body in a planar view, being formed between the adjacent two side surfaces located on the same side of the board main body along a thickness direction of the front surface and the rear surface or at a corner portion between the adjacent two side surfaces of the board main body along the thickness direction of the front surface and the rear surface, and the metalized layer formed on the surface of the concave portion being electrically connected to the ground layer.

10. The method for manufacturing a wiring board according to claim 8 or 9,
**characterized in that**:
a step of forming the conducting layer and a second insulating layer along a side direction of the side surface is performed on the side surface of the board main body from which the end surface of the wiring conductor for plating is not exposed.
